(19) Europäisches Patentamt
European Patent Office
Office européen des brevets

(11) **EP 2 771 906 B1**

(12) **FASCICULE DE BREVET EUROPEEN**

(45) Date de publication et mention de la délivrance du brevet:
**18.11.2015 Bulletin 2015/47**

(51) Int Cl.:
***H01L 21/324*** *(2006.01)*

(21) Numéro de dépôt: **12795492.3**

(22) Date de dépôt: **26.10.2012**

(86) Numéro de dépôt international:
**PCT/FR2012/000436**

(87) Numéro de publication internationale:
**WO 2013/060949 (02.05.2013 Gazette 2013/18)**

(54) **PROCÉDÉ DE LISSAGE D'UNE SURFACE PAR TRAITEMENT THERMIQUE**

VERFAHREN ZUM GLÄTTEN EINER FLÄCHE MITTELS WÄRMEBEHANDLUNG

PROCESS FOR SMOOTHING A SURFACE VIA HEAT TREATMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.10.2011 FR 1103276**

(43) Date de publication de la demande:
**03.09.2014 Bulletin 2014/36**

(73) Titulaire: **Commissariat à l'Énergie Atomique et aux Énergies Alternatives 75015 Paris (FR)**

(72) Inventeurs:
• **JOUANNEAU, Thomas F-38360 Sassenage (FR)**
• **BOGUMILOWICZ, Yann F-38100 Grenoble (FR)**

(74) Mandataire: **Talbot, Alexandre et al Cabinet Hecké Europole 10, rue d'Arménie - BP 1537 38025 Grenoble Cedex 1 (FR)**

(56) Documents cités:
**EP-A2- 1 363 322**    **EP-A2- 1 614 775**
**JP-A- 2005 217 374**    **US-A- 4 830 987**

• **ARMIENTO C A ET AL: "CAPLESS RAPID THERMAL ANNEALING OF GAAS IMPLANTED WITH SI USING AN ENHANCED OVERPRESSURE PROXIMITY METHOD", JOURNAL OF THE ELECTROCHEMICAL SOCIETY, ECS, vol. 134, no. 8A, 1 août 1987 (1987-08-01) , pages 2010-2016, XP000840329, ISSN: 0013-4651**

## Description

### Domaine technique de l'invention

L'invention concerne un procédé de lissage, en utilisant un traitement thermique, d'une surface rugueuse d'un premier substrat comprenant en surface un alliage semi-conducteur à base d'au moins deux éléments choisis parmi Ga, As, Al, In, P et N.

### État de la technique

Les substrats en matériau semi-conducteur sont généralement obtenus par sciage d'un lingot à base du même matériau semi-conducteur. Le procédé de sciage produit des substrats ayant des surfaces rugueuses et comportant des défauts structurels tels que des dislocations dans le réseau cristallin. Il existe également une technique de report de films minces en matériau semi-conducteur, connue sous le nom de Smart Cut™. Cette technique comprend en général trois étapes : une première étape d'implantation ionique d'hydrogène et/ou de gaz rares pour créer au sein du substrat initial une couche fragile enterrée, une deuxième étape de solidarisation du substrat initial avec un substrat de réception (ou raidisseur), une troisième étape de traitement thermique pour obtenir une fracture au niveau de la zone fragile. Cette étape de fragilisation peut être assistée par une application de forces mécaniques. Les surfaces obtenues après fracture, notamment dans le cas de transfert de couches minces en alliage de gallium et d'arsenic (GaAs) ou en alliage d'indium et de phosphore (InP) peuvent présenter une forte rugosité, incompatible avec l'application visée.

Après le procédé de sciage ainsi qu'après le procédé Smart Cut™, il est nécessaire de réduire la rugosité de surface des substrats avant leur utilisation, notamment, pour la réalisation d'un dispositif microélectronique. La rugosité de surface est communément évaluée par microscopie à force atomique noté AFM. Ce dispositif permet de mesurer la rugosité RMS (en anglais « Root Mean Square ») qui correspond à la valeur de l'écart quadratique moyen de la rugosité. La rugosité RMS quantifie en moyenne, sur une surface balayée de quelques $\mu m^2$, la hauteur des pics et creux de rugosité par rapport à la hauteur moyenne. À moins d'indications contraires, les valeurs de rugosité qui seront fournies par la suite seront des valeurs RMS mesurées par AFM sur une surface balayée de 5 $\mu m$ x 5 $\mu m$.

Afin de réduire la rugosité de surface des substrats en matériau semi-conducteur, le polissage mécanochimique (ou CMP) est l'une des solutions les plus utilisées dans le domaine de la microélectronique. Cette solution est cependant, onéreuse et nécessite un temps de réalisation relativement long pour des surfaces très rugueuses. Pour réduire la rugosité d'un substrat, une solution alternative utilisant un lissage thermique peut également être mise en oeuvre. Cette solution consiste à réaliser un traitement thermique du substrat à haute température. Le traitement thermique permet de donner de la mobilité aux atomes de surface, ce qui permet de diminuer l'énergie de surface en réduisant la rugosité. Cette solution est utilisée principalement pour des substrats en silicium. La transposition de cette technique de lissage thermique aux substrats en alliages semi-conducteurs, par exemple, en GaAs ou en InP, reste cependant difficile à réaliser.

En effet, lors de traitements à des températures élevées, typiquement, supérieures à 500 °C pour le GaAs et l'InP, ces alliages semi-conducteurs peuvent se décomposer. Ce phénomène peut être évité en réalisant ces traitements thermiques sous des atmosphères spécifiques. Smith et al. décrit, par exemple, dans l'article intitulé « Surface topography changes during the growth of GaAs by molecular beam epitaxy », Applied Physics Letters , 59(25), (1991), l'utilisation d'un traitement thermique sous une atmosphère contenant de l'arsenic pour améliorer la rugosité d'un substrat en GaAs. Cependant, ce type de traitement thermique nécessite la manipulation de gaz dangereux comme l'arsine ($AsH_3$) et implique la mise en place d'une installation spécifique coûteuse.

Par ailleurs, la demande de brevet FR 2867307 décrit une réalisation d'un traitement thermique spécifique de guérison de la structure cristalline après une étape de fracture obtenue par le procédé Smart Cut™. Ce procédé s'applique à tous les matériaux semi-conducteurs et plus particulièrement au semi-conducteur à base d'alliage de silicium et de germanium (SiGe). Ce traitement thermique a également pour effet de lisser les surfaces obtenues après fracture alors que les surfaces sont encore en contact. Des précautions doivent être prise en contact lors de ce traitement thermique, notamment en termes de budget thermique (couple temps et température du traitement thermique) afin d'éviter que les deux surfaces en contact ne se resolidarisent de façon irréversible. De plus, des rayures peuvent apparaître sur les faces puisque les surfaces restent en contact après fracture. En effet, ces rayures peuvent provenir de la présence de particules ou de pics de matière qui apparaissent au moment de la fracture entre les surfaces en regard.

JP 2005 217374 A (SUMITOMO ELECTRIC INDUSTRIES) 11 août 2005 (2005-08-11) divulge un procédé de lissage d'une surface rugueuse d'un substrat.

### Objet de l'invention

Dans certains domaines de la micro et nanotechnologie, il existe un besoin de fournir des substrats présentant au moins en surface un alliage semi-conducteur à base d'au moins deux éléments choisis parmi Ga, As, Al, In, P et N, avec des surfaces lisses obtenues selon un procédé facile à mettre en oeuvre, peu coûteux et évitant l'utilisation de gaz dangereux.

On tend à satisfaire ce besoin en prévoyant un procédé de lissage d'une surface rugueuse d'un premier substrat en un alliage semi-conducteur à base d'au moins deux éléments choisis parmi Ga, As, Al, In, P et N, dans lequel un second substrat est placé en regard du premier substrat de manière à ce que la surface rugueuse du premier substrat soit en regard d'une surface du second substrat. Les deux substrats sont séparés d'une distance d au moins égale à 10 μm, la portion en regard des premier et second substrats définissant ainsi un espace de confinement. Ledit procédé de lissage comporte également une étape de chauffage du premier substrat de manière à désorber partiellement un des éléments dudit alliage et à atteindre la pression de vapeur saturante de cet élément dans l'espace de confinement et à atteindre une mobilité des atomes de surface suffisante pour réduire la rugosité de la surface rugueuse.

## Description sommaire des dessins

D'autres avantages et caractéristiques ressortiront plus clairement de la description qui va suivre de modes particuliers de réalisation de l'invention données à titre d'exemples non limitatifs et représentés aux dessins annexés, dans lesquels :

- la figure 1 représente, schématiquement et en coupe, un mode de réalisation d'un procédé de traitement thermique d'un substrat par pseudo-contact ;
- la figure 2 représente, schématiquement et en coupe, un premier mode de réalisation d'un procédé de lissage d'une surface rugueuse d'un substrat selon l'invention ;
- la figure 3 représente, schématiquement et en coupe, un second mode de réalisation d'un procédé de lissage d'une surface rugueuse d'un substrat selon l'invention ;
- les figures 4 et 5 représentent, schématiquement et en coupe, une variante du second mode de réalisation d'un procédé de lissage d'une surface rugueuse d'un substrat selon l'invention ;
- les figures 6A à 6C représentent, schématiquement et en coupe, une nacelle utilisée dans un mode de réalisation d'un procédé de lissage d'une surface rugueuse d'un substrat selon l'invention.

## Description de modes particuliers de réalisation

Un moyen fiable, pratique et peu onéreux pour réaliser des substrats comportant un alliage semi-conducteur à base d'au moins deux éléments choisis parmi Ga, As, Al, In, P et N ayant au moins une surface lisse dépourvue de défauts structurels, consiste à utiliser un lissage par traitement thermique avec des équipements et des atmosphères standard en créant localement au niveau de la surface à traiter une atmosphère évitant une décomposition trop importante de cet alliage.

Il a déjà été proposé pour l'activation de dopants ou encore pour l'amélioration des propriétés électriques des substrats en alliages semi-conducteurs, par exemple, en GaAs ou en InP de réaliser des traitements thermiques en posant deux substrats l'un sur autre. Cette solution, dite procédé pseudo-contact (en anglais « proximity cap »), permet de limiter le phénomène de décomposition des substrats en alliages semi-conducteurs lors de ces traitements thermiques spécifiques.

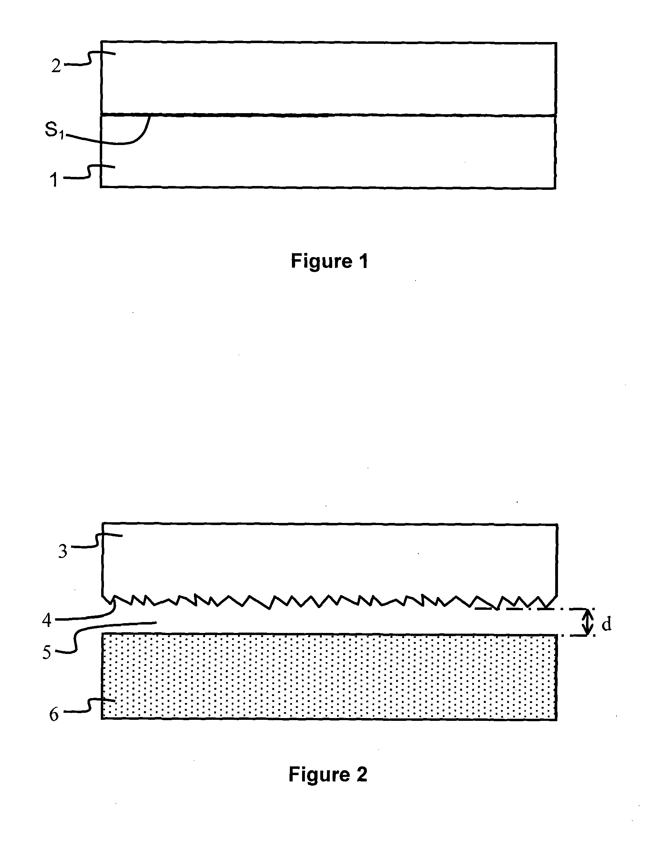

Comme représenté à la figure 1, le procédé pseudo-contact consiste à placer un substrat de protection 2 sur la surface utile $S_1$ d'un substrat 1 et à traiter thermiquement le substrat 1 ainsi protégé. Le substrat 2 de protection est choisi de manière à créer avec le substrat 1 une atmosphère locale, au voisinage de la surface utile $S_1$, qui limite la décomposition de l'alliage semi-conducteur lors du traitement thermique. À titre d'exemple, lorsque les substrats 1 et 2 sont en GaAs, il se crée une atmosphère locale saturée en arsenic entre les deux substrats 1 et 2 mis en contact, lors du traitement thermique. Cette atmosphère locale est générée par une légère décomposition temporaire de GaAs à chaque surface des substrats 1 et 2 mis en contact. La saturation de l'atmosphère locale en arsenic permet ainsi d'éviter la décomposition de la surface utile $S_1$ du substrat 1 en GaAs lors du traitement thermique.

Les traitements thermiques de l'art antérieur, pour l'activation de dopants ou encore pour l'amélioration des propriétés électriques ont été réalisés sur des surfaces lisses avec des budgets thermiques limités typiquement pendant 10 minutes à 650 °C, ou pendant 1 minute à 700 °C ou encore pendant 20 secondes à 1000 °C. Aucun effet n'a été constaté sur la rugosité.

La transposition du procédé pseudo-contact au domaine du traitement des surfaces, en particulier au lissage des substrats en alliages semi-conducteurs, n'est pas adaptée car le lissage thermique nécessite un traitement thermique avec un budget thermique important. Or, en appliquant une température élevée, ce type de traitement thermique risque de causer l'adhérence des deux substrats placés l'un sur l'autre dans un procédé pseudo-contact. Pour éviter les problèmes de collage, un substrat comprenant une surface à lisser peut être séparé d'un autre substrat d'une distance d non nulle pendant un traitement thermique de lissage comme détaillé dans l'exemple suivant.

Selon un mode particulier de réalisation représenté à la figure 2, un procédé de lissage d'une surface rugueuse 4 d'un premier substrat 3 utilise un second substrat 6. Ladite surface rugueuse 4 est en un alliage semi-conducteur à base d'au moins deux éléments choisis parmi Ga, As, Al, In, P, et N. De préférence, ledit alliage est un alliage semi-conducteur de type III-V. L'alliage de la surface rugueuse 4 peut également être un alliage semi-conducteur dopé. À titre d'exemple, l'alliage semi-conducteur peut être dopé par un élément choisi parmi Si, Ge, Cr, Fe, S, Sn et Zn, avec une proportion atomique inférieure à 1 pour mille.

Le second substrat 6 est placé en regard du premier substrat 3, les deux substrats étant séparés d'une distance d au moins égale à 10 μm de manière

que les deux surfaces en regard définissant l'espace de confinement ne puissent adhérer l'une à l'autre lors du traitement thermique. Les deux matériaux formant les deux surfaces des deux substrats 3 et 6 en regard ne sont pas en contact direct. Avantageusement, les premier 3 et second 6 substrats ne sont pas en contact. Autrement dit, aucun élément ou une partie du second substrat 6 n'est en contact avec un élément ou une partie du premier substrat 3. En outre, le second substrat 6 est disposé de manière à ce que la surface rugueuse 4 soit séparée d'une surface du second substrat 6 de la distance d qui est au moins égale à 10 $\mu$m. Les portions en regard des premier et second substrats 3 et 6 définissent ainsi un espace de confinement 5. Avantageusement, l'espace de confinement 5 est un espace ouvert ce qui évite tout problème de surpression entre les deux substrats en regard et donc une fragilisation des substrats. On entend par surface rugueuse, une surface présentant des aspérités et nécessitant un traitement pour diminuer ses aspérités avant l'utilisation de ladite surface. Une surface rugueuse a typiquement une rugosité mesurée supérieure à 5 nm RMS.

On entend par le fait que la surface rugueuse 4 et la surface du substrat 6 soient séparées d'une distance d'au moins égale à 10 $\mu$m que pour tout échantillon de 1 $\mu$m x 1 $\mu$m de cette surface rugueuse 4, la distance entre le plan moyen de cet échantillon et le plan moyen de l'échantillon de 1 $\mu$m x 1 $\mu$m de la surface du second substrat 6 en regard soit d'au moins de 10 $\mu$m. Le plan moyen sur un échantillon étant défini par sa hauteur $z_m$ par rapport à un plan de référence arbitraire selon la formule :

$$z_m = \frac{1}{m \times n} \sum_{i=1}^{m} \sum_{j=1}^{n} z(i,j)$$

où z(i,j) représente la hauteur d'un point (i,j) de l'échantillon par rapport à ce plan de référence, 256 x 256 points étant mesurés par échantillon.

Le premier substrat 3 est ensuite chauffé de manière à désorber partiellement un des éléments dudit alliage semi-conducteur et à atteindre une pression de vapeur saturante de cet élément dans l'espace de confinement. Autrement dit, un traitement thermique est réalisé de manière à chauffer le premier substrat 3. La distance de séparation d, et la température et la durée du traitement thermique sont choisies de manière à obtenir une atmosphère contenant une vapeur saturante de l'un des éléments de l'alliage semi-conducteur de la surface rugueuse 4 et à fournir une mobilité aux atomes de surface suffisante pour réduire la rugosité. La distance d permet d'éviter le collage de la surface rugueuse 4 et de la surface du second substrat 6 lors de la mise en oeuvre du traitement thermique. Ainsi, le traitement thermique peut être réalisé à une température élevée pour obtenir un lissage rapide et efficace de la surface rugueuse 4, en évitant tout risque de collage.

Préférentiellement, le traitement thermique destiné à chauffer le premier substrat 3 est réalisé à une température supérieure à 500 °C. Ce traitement thermique doit bien sûr être réalisé à une température inférieure à la température de fusion de l'alliage semi-conducteur.

Les premier 3 et second 6 substrats ne sont pas en contact direct et la séparation de la surface rugueuse 4 de la surface du second substrat 6 peut être réalisée par tout moyen connu, préférentiellement par au moins une cale ayant une épaisseur au moins égale à la distance de séparation d. Ainsi, entre les premier 3 et second 6 substrats il y a principalement une absence de matière, et localement des cales. La disposition des cales est réalisée de manière à avoir un espace de confinement ouvert. À titre d'exemple, des cales (non représentées aux figures) ayant une épaisseur au moins égale à la distance d peuvent être disposées sur la surface du second substrat 6. On tiendra compte pour définir l'épaisseur des cales nécessaire, notamment de la position de ces cales sur le second substrat 6, de la courbure de la surface (notée « baw ») des premier et second substrats 3 et 6 et des variations d'épaisseur des substrats (notées « TTV », en anglais « total thickness variation »). Le premier substrat 3 est ensuite posé sur ces cales. De préférence, les cales sont agencées de manière à ce qu'elles soient en contact uniquement avec les bords périphériques du premier substrat 3. Par ailleurs, les cales sont choisies de manière à éviter tout collage avec les premier 3 et second 6 substrats. De préférence, les cales sont à base d'un matériau différent, du matériau du premier substrat 3, et du matériau du second substrat 6. Les cales peuvent être également à base d'un matériau dont les caractéristiques ne favorisent pas le collage dudit matériau avec les premier et second substrats 3 et 6, comme le quartz, le silicium ou encore le carbure de silicium (SiC). Par ailleurs, les cales peuvent avoir une qualité de surface, par exemple une surface très rugueuse ou comportant peu de surface de contact, qui permet d'éviter le collage entre les cales et les premier 3 et second 6 substrats. En variante, il est possible de prévoir des mécanismes de maintien des substrats 3 et 6. À titre d'exemple, des moyens d'aspiration de substrats peuvent être utilisés pour maintenir les substrats 3 et 6 à une distance d de séparation donnée.

Le procédé de lissage de la surface rugueuse 4 comporte une étape essentielle de traitement thermique. Cette étape est réalisée de manière à fournir un important budget thermique aux atomes de surface. Selon la nature de l'alliage semi-conducteur de la surface rugueuse 4, on choisira un budget thermique suffisamment efficace pour que les atomes de surface puissent acquérir une mobilité permettant de diminuer l'énergie de surface et réduire la rugosité. Typiquement pour du GaAs et de l'InP, le budget thermique sera de l'ordre de, voire supérieur à 30 minutes à 700 °C et à 2 minutes à 1000°C.

L'étape de traitement thermique est réalisée selon tout procédé connu, par exemple, en utilisant un four tubulaire classique ou, un four à traitement thermique rapide noté RTA (en anglais « Rapid Thermal Annealing »).

La disposition astucieuse du substrat 3 par rapport à la surface du second substrat 6, permet l'utilisation d'un traitement thermique classique pour le lissage de la surface rugueuse 4. En effet, selon ce mode de réalisation, le lissage thermique est réalisé en utilisant un traitement thermique sous des atmosphères conventionnelles, par exemple, des atmosphères neutres telles que l'azote ($N_2$), l'hélium (He) ou l'argon (Ar) ou encore un mélange comportant l'un de ces gaz, par exemple un mélange de $N_2$ et de $H_2$. Au début du traitement thermique, l'alliage semi-conducteur de la surface rugueuse 4 se décompose en créant localement une atmosphère enrichie par au moins un des éléments chimiques constituant l'alliage semi-conducteur. L'espace de confinement 5 comporte alors une atmosphère locale saturée par cet élément chimique, ce qui permet par la suite, de minimiser la décomposition de la surface rugueuse 4.

Par ailleurs, le maintien de la surface rugueuse 4 et de la surface du substrat 6 à au moins une distance de 10 $\mu$m permet avantageusement, d'éviter tout risque de collage direct entre ces deux surfaces. Ainsi les contraintes sur les conditions du traitement thermique de lissage sont relâchées. Autrement dit, il est possible de mettre en oeuvre un traitement thermique à une température plus élevée ou pendant un temps plus long sans risque de collage. L'augmentation de la température du traitement thermique permet d'obtenir un lissage équivalent voire de meilleure qualité avec une durée de traitement thermique plus courte, ce qui rend le procédé de lissage moins cher et plus efficace.

De préférence, la distance de séparation d entre la surface rugueuse 4 et la surface du second substrat 6 est choisie de manière à être la plus faible possible. En effet, l'efficacité du confinement dépend de la facilité à saturer l'espace de confinement 5 en un élément de l'alliage semi-conducteur du premier substrat 3 : plus cette distance d est grande, plus le volume à saturer sera important. De plus l'augmentation de la distance d facilite la fuite de l'espèce saturante vers l'extérieur de l'espace de confinement 5. Avantageusement, la distance de séparation d est inférieure à 2 mm, voire 1 mm ou 500 nm.

En ajustant la distance de séparation d et en fournissant un budget thermique suffisant au premier substrat 3, la rugosité de la surface 4 peut être diminuée tout en évitant la décomposition de l'alliage du premier substrat 3.

Le second substrat 6 peut, par exemple, être un support de substrats, réalisé en matériau stable thermiquement par rapport au premier substrat 3, c'est-à-dire qui supporte des températures supérieures à la température de fusion du matériau du premier substrat 3 (environ 1238°C pour GaAs et environ 1062°C pou InP). De préférence, le second substrat 6 est un support de réception de plaques pour four RTA, par exemple, un suscepteur en graphite comprenant un revêtement en alliage de carbure de silicium (SiC).

Afin d'assurer un lissage thermique de la surface rugueuse 4, le traitement thermique est réalisé à des températures relativement hautes, par exemple, comprises entre 800 et 1200 °C pour le GaAs et entre 700 et 1000 °C pour l'InP. Cependant, pour garder les mêmes caractéristiques structurelles du premier substrat 3, le traitement thermique est, avantageusement, réalisé à une température inférieure à la température de fusion de l'alliage semi-conducteur du substrat 3.

L'alliage semi-conducteur du premier substrat 3 est, de préférence, un alliage semi-conducteur à base de GaAs, dans ce cas, le traitement thermique est, avantageusement, réalisé à une température supérieure ou égale à 700 °C, voire supérieure à 800°C ou 900°C mais inférieure à sa température de fusion, et donc typiquement inférieure à 1200°C. L'alliage semi-conducteur du premier substrat 3 peut, également, être un alliage d'InP, dans ce cas, le traitement thermique est, avantageusement, réalisé à une température supérieure ou égale à 600 °C, voire supérieure à 700°C ou 800°C mais inférieure à sa température de fusion, et donc typiquement inférieure à 1000°C.

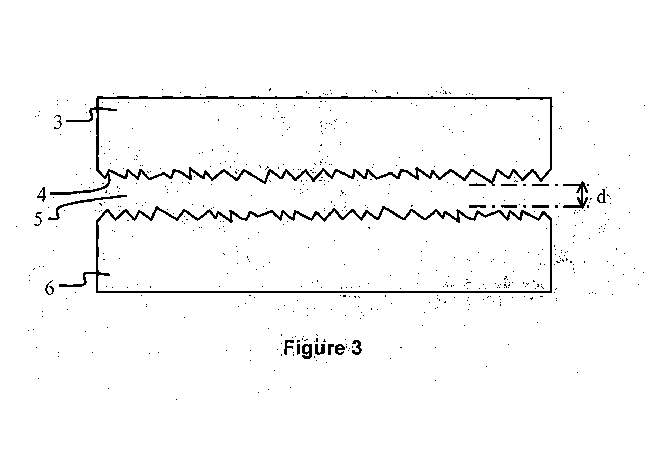

Selon un autre mode de réalisation particulier représenté à la figure 3, la surface du second substrat 6 comporte un alliage semi-conducteur à base d'au moins deux éléments choisis parmi Ga, As, Al, In, P et N. De préférence, l'alliage semi-conducteur de la surface du second substrat 6 est identique à celui de la surface rugueuse 4. La surface du second substrat 6 peut être rugueuse, typiquement elle a une rugosité RMS supérieure à 5 nm. Suivant ce mode de réalisation, une saturation plus rapide de l'espace de confinement 5 peut être effectuée, puisque les surfaces des premier et second substrats 3 et 6 y participent, permettant ainsi le lissage simultané de la surface rugueuse 4 et de la surface du second substrat 6.

Préférentiellement, la distance de séparation d est de l'ordre de la somme des courbures maximales respectives des substrats 3 et 6, à laquelle on rajoutera une marge pour tenir compte de la variation d'épaisseur des substrats 3 et 6. Par exemple, pour des plaques de 100 mm, la courbure maximale est de l'ordre de 20 $\mu$m. Ainsi, pour des plaques (substrats 3 et 6) de 100 mm, la distance de séparation d lors du traitement thermique de lissage sera typiquement de l'ordre de 50 $\mu$m.

À titre d'exemple, un procédé de lissage utilisant un traitement thermique d'une surface rugueuse en GaAs a été mis en oeuvre. Cette surface a été obtenue à la suite d'un transfert d'une couche en GaAs sur un substrat support en silicium, par le procédé Smart Cut™. Les conditions d'implantation pour le transfert du GaAs étaient les suivantes : co-implantation de $5.10^{15}$ He$^+$/cm$^2$ à 105 keV et de $3.10^{16}$ H$_2^+$/cm$^2$ à 160keV. La fracture a été obtenue à une température de l'ordre de 230 °C. L'étape de fracture a produit une surface de GaAs ayant une rugosité mesurée de 21 nm RMS.

Les substrats ainsi obtenus, ont été recuits, à pression ambiante, dans un four standard RTA sous une atmosphère neutre (N₂). Avant chaque traitement thermique, les substrats ont été disposés deux par deux avec leur face de GaAs en regard. Les substrats GaAs de chaque couple ont été séparés par des cales ayant des épaisseurs comprises entre 50 μm et 400 μm. La rugosité de surface mesurée a été diminuée pour des températures de traitement thermiques de lissage supérieures ou égales à 700 °C. En particulier, pour un traitement à 1000 °C pendant 2 min, et une distance de séparation d de 50 μm entre les surfaces en GaAs, la rugosité a été abaissée jusqu'à 3,2 nm RMS.

La rugosité mesurée des surfaces en GaAs diminue au fur et à mesure que la distance de séparation d se réduit. En effet, la rugosité a été abaissée de 4,6 nm RMS à 3,8 nm RMS puis 3,2 nm RMS lorsque l'épaisseur des cales est passée de 400 à 220 μm puis 50μm.

À titre d'exemples comparatifs, des substrats GaAs ont été recuits dans un four à tube sous une atmosphère N₂, à pression réduite et à une température de 800 °C pendant une heure. Chaque substrat GaAs a été disposé dans une fente d'une nacelle en quartz avant l'introduction dans le four. Les fentes étant espacées d'environ 4 mm, les substrats GaAs ont pu être recuits dans une disposition en regard avec une distance de séparation d d'environ 4 mm. Suivant ces conditions de traitement thermique, la rugosité de surface des substrats GaAs a été fortement augmentée rendant ainsi impossible la mesure de la rugosité par interférométrie. Cette forte augmentation de la rugosité des substrats GaAs recuits, suivant cette disposition, est générée par la décomposition de la surface des substrats GaAs. En effet, la distance de séparation d entre les substrats GaAs est trop importante, elle permet la circulation du flux d'azote gazeux au voisinage des surfaces des substrats GaAs et la saturation locale en arsenic n'est plus possible.

Des essais similaires ont été réalisés après report d'une couche en InP par le procédé Smart Cut™. L'étape de fracture a généré deux surfaces rugueuses en InP, dont une au moins a une rugosité mesurée de 14 nm RMS. Les deux surfaces en InP obtenues après l'étape de fracture ont été placées en regard de manière à être séparées par des cales de 50 μm. Ensuite, un traitement thermique dans un four RTA à 700 °C pendant 30 minutes des deux surfaces en InP séparées par des cales de 50 μm a permis d'abaisser la rugosité à environ 4 nm RMS. Un traitement thermique à 800°C pendant 30 minutes suivant une configuration « pseudo-contact » a entraîné le collage des deux surfaces en InP.

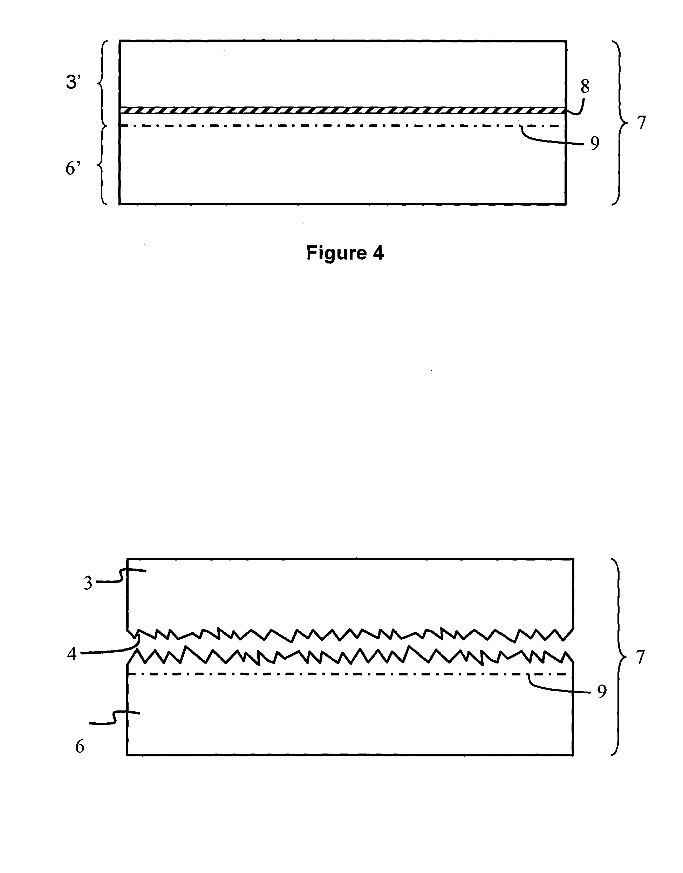

Selon un mode particulier de mise en oeuvre représenté aux figures 4 et 5, les surfaces rugueuses sont obtenues à partir d'un même support 7. Comme illustré à la figure 4, une zone de fragilisation 8 est réalisée à l'intérieur du support 7. La zone de fragilisation 8 est avantageusement obtenue au moyen d'une implantation d'un élément fragilisant. Le support 7 peut être formé par collage d'une plaquette donneuse 3' et d'une plaquette réceptrice 6' après l'étape d'implantation de l'élément fragilisant dans la plaquette donneuse 3'. Le collage étant réalisé au niveau de l'interface de collage 9. Comme illustré à la figure 5, le support 7 est, ensuite séparé au niveau de la zone de fragilisation 8 pour former les premier et second substrats 3 et 6. La surface rugueuse 4 du premier substrat 3 et la surface du second substrat 6 sont formées par la zone de fragilisation 8. Avantageusement, la zone de fragilisation 8 est obtenue au moyen d'une implantation d'hydrogène et/ou de gaz rares, et l'étape de séparation est réalisée au moyen d'un traitement thermique.

Après l'étape de séparation, des moyens mécaniques sont employés pour maintenir les premier et second substrats 3 et 6 à une distance de séparation d supérieure à 10 μm, préférentiellement de l'ordre de 50 μm. Ces moyens mécaniques peuvent comporter par exemple, des coins répartis de manière sensiblement régulière autour de la périphérie des substrats 3 et 6, préférentiellement au niveau du biseau. Les moyens mécaniques peuvent également consister en des moyens d'insertion tel qu'une lame ou une guillotine ou encore en des moyens d'aspiration disposés de part et d'autre des substrats. Ensuite, un traitement thermique permettant le lissage des surfaces des substrats 3 et 6 est réalisé tel que décrit ci-dessus.

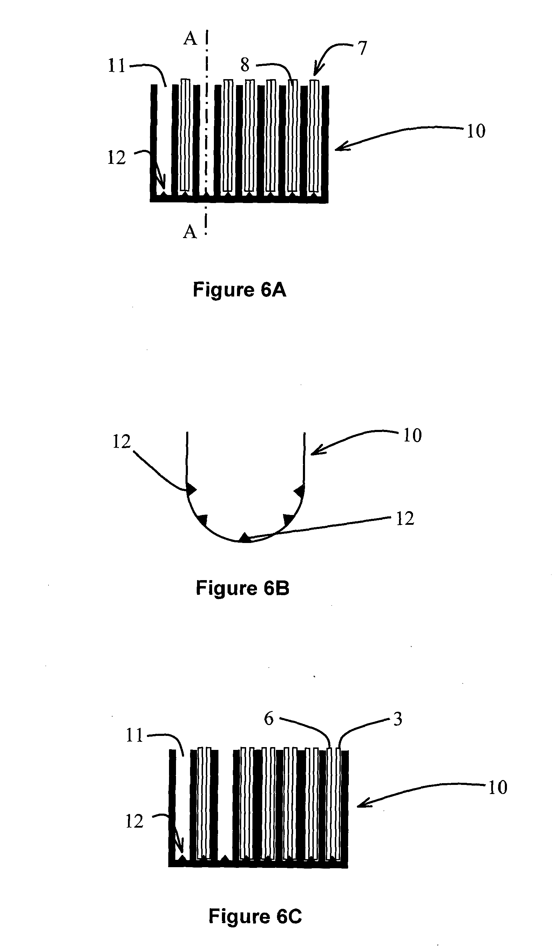

Avantageusement, le traitement thermique de séparation et le traitement thermique de lissage sont réalisés dans le même four. Comme illustré aux figures 6A à 6C, le procédé de lissage selon l'invention est avantageusement utilisé en association du procédé Smart Cut™ pour obtenir des surfaces de faible rugosité, notamment en GaAs ou en InP. De tels matériaux peuvent être par exemple reportés sur des substrats de silicium. L'étape de séparation ou de fracture est réalisée collectivement.

Selon un exemple de réalisation, un grand nombre de supports 7 à séparer est placé verticalement dans des fentes 11 d'une nacelle 10, avantageusement en quartz (figure 6A). Les fentes 11 de la nacelle 10 sont espacées l'une de l'autre d'une distance pouvant atteindre 4 mm. La nacelle est ensuite introduite dans un four pour subir une étape de traitement thermique destinée à séparer chaque support au niveau de la zone de fragilisation 8 obtenue par implantation. Ce traitement thermique de séparation est réalisé entre 200 et 300 °C suivant les conditions d'implantation de fragilisation. En variante le traitement thermique de séparation peut être assisté par une application de forces mécaniques. Comme illustré à la figure 6B, chaque fente 11 de la nacelle 10 est munie de coins 12, par exemple répartis de manière sensiblement régulière autour de la périphérie des supports 7, notamment au niveau du biseau. Les coins 12 sont destinés à maintenir les surfaces obtenues (les surfaces des premier 3 et second 6 substrats) après fracture à une distance de séparation de l'ordre de 50 μm. Les coins 12 peuvent également servir pour induire la séparation.

Comme illustré à la figure 6C, après l'étape de fracture et de maintien des substrats 3 et 6 obtenus à une distance de séparation, la température du four est élevée. Le four permet ainsi de réaliser un traitement thermique de lissage des premier 3 et second 6 substrats tel que décrit ci-dessus. Pour des surfaces reportées en InP, le traitement thermique est préférentiellement réalisé à 800 °C pendant 30 minutes. Ce procédé a permis de ramener la rugosité de 14 nm RMS après l'étape de fracture à 4 nm RMS après le traitement thermique de lissage. De manière analogue, pour des surfaces reportées en GaAs, un traitement thermique de lissage, suivant les mêmes conditions, a permis d'obtenir une rugosité de l'ordre de 3 nm RMS, contre une rugosité de 21 nm RMS mesurée après l'étape de fracture.

Il est possible également d'associer le traitement thermique de lissage selon l'invention avec une étape supplémentaire de CMP afin d'abaisser encore la rugosité de surface. Cette étape de CMP additionnelle est plus courte qu'une étape de CMP usuelle, et donc moins onéreuse, que si elle avait été entreprise sans traitement thermique de lissage préalable.

**Revendications**

1. Procédé de lissage d'une surface rugueuse (4) d'un premier substrat (3) comprenant les étapes suivantes :

   - fournir le premier substrat (3) avec la surface rugueuse (4) en un alliage semi-conducteur à base d'au moins deux éléments choisis parmi Ga, As, Al, In, P et N ;
   - placer un second substrat (6) avec une surface en regard de la surface rugueuse (4) du premier substrat (3), les deux substrats (3 et 6) étant séparés d'une distance d au moins égale à 10 μm, la portion en regard des deux substrats (3, 6) définissant un espace de confinement (5) ;
   - chauffer le premier substrat (3) de manière à désorber partiellement un des éléments de l'alliage semi-conducteur et atteindre la pression de vapeur saturante de cet élément dans l'espace de confinement (5) et à atteindre une mobilité des atomes de surface suffisante pour réduire la rugosité de la surface rugueuse (4).

2. Procédé de lissage selon la revendication 1, **caractérisé en ce que** la distance de séparation d est inférieure à 2 mm.

3. Procédé de lissage selon l'une des revendications 1 et 2, **caractérisé en ce que** l'alliage est un alliage de galium et d'arsenic et **en ce que** le chauffage est réalisé à une température supérieure ou égale à 700 °C.

4. Procédé de lissage selon l'une des revendications 1 et 2, **caractérisé en ce que** l'alliage est un alliage d'indium et de phosphore et **en ce que** le chauffage est réalisé à une température supérieure ou égale à 600 °C.

5. Procédé de lissage selon l'une quelconque des revendications 1 à 4, **caractérisé en ce que** la surface du second substrat (6) comporte un alliage semi-conducteur à base d'au moins deux éléments choisis parmi Ga, As, Al, In, P et N.

6. Procédé de lissage selon la revendication 5, **caractérisé en ce que** la surface du second substrat (6) est rugueuse et **en ce qu'**un lissage simultané de la surface rugueuse (4) et de la surface du second substrat (6) est réalisé.

7. Procédé de lissage selon la revendication 6, **caractérisé en ce que** l'alliage de la surface du second substrat (6) est identique à celui de la surface rugueuse (4) du premier substrat (3).

8. Procédé de lissage selon l'une quelconque des revendications 1 à 7, **caractérisé en ce que** la surface rugueuse (4) est séparée de la surface du second substrat (6) par au moins une cale ayant une épaisseur au moins égale à la distance de séparation d.

9. Procédé de lissage selon la revendication 7, **caractérisé en ce qu'**il comporte les étapes suivantes :

   - prévoir un support (7) comportant une zone de fragilisation (8) disposée à l'intérieur du support (7) ;
   - séparer le support au niveau de la zone de fragilisation pour former les premier et second substrats (3, 6), la surface rugueuse (4) du premier substrat (3) et la surface du second substrat (6) étant formée par la zone de fragilisation (8).

10. Procédé de lissage selon la revendication 9, **caractérisé en ce que** la zone de fragilisation (8) est obtenue au moyen d'une implantation d'hydrogène et/ou de gaz rares, et **en ce que** la séparation comporte une étape de traitement thermique.

11. Procédé de lissage selon la revendication 9 ou 10, **caractérisé en ce que** les premier et second substrats (3, 6) sont séparés au moyens de coins répartis autour de la périphérie desdits substrats (3, 6).

**Patentansprüche**

1. Vorfahren zum Glätten einer rauhen Oberfläche (4) eines ersten Substrats (3), umfassend die folgenden Schritte:

- Bereitstellen des ersten Substrats (3) mit der rauhen Oberfläche (4) aus einer Halbleitetlegierung auf Basis von wenigstens zwei Elementen, die aus Ga, As. Al, In, P und N ausgewählt sind;
- Anordnen eines zweiten Substrats (6) mit einer Oberfläche gegenüber der rauhen Oberfläche (4) des ersten Substrats (3), wobei die beiden Substrate (3 und 6) um einen Abstand d von wenigstens gleich 10 μm getrennt sind, wobei der gegenüberliegende Abschnitt der beiden Substrate (3, 6) einen Umschließungsraum (5) definiert;
- Erhitzen des ersten Substrats (3), um eines der Elemente der Halbleiterlegierung teilweise zu desorbieren und den Sättigungsdampfdruck dieses Elements in dem Umschließungsraum (5) zu erreichen und um eine Beweglichkeit der Atome mit ausreichender Fläche zu erreichen, um die Rauheit der rauhen Oberfläche (4) zu reduzieren.

**2.** Glättungsverfahren nach Anspruch 1, **dadurch gekennzeichnet, dass** der Trennungsabstand d kleiner als 2 mm ist.

**3.** Glättungsverfahren nach einem der Ansprüche 1 und 2, **dadurch gekennzeichnet, dass** die Legierung eine Gallium-Arsen-Legierung ist und dass das Erhitzen bei einer Temperatur von über oder gleich 700 °C durchgeführt wird.

**4.** Glättungsverfahren nach einem der Ansprüche 1 und 2, **dadurch gekennzeichnet, dass** die Legierung eine Indium-Phosphor-Legierung ist und dass das Erhitzen bei einer Temperatur von über oder gleich 600 °C durchgeführt wird.

**5.** Glättungsverfahren nach einem der Anspruch 1 bis 4, **dadurch gekennzeichnet, dass** die Oberfläche des zweiten Substrats (6) eine Halbleiterlegierung auf Basis von wenigstens zwei Elementen, die aus Ga, As, Al. In, P und N ausgewählt sind, umfasst.

**6.** Glättungsverfahren nach Anspruch 5, **dadurch gekennzeichnet, dass** die Oberfläche des zweiten Substrats (6) rauh ist und dass ein gleichzeitiges Glätten der rauhen Oberfläche (4) und der Oberfläche des zweiten Substrats (6) vollzogen wird.

**7.** Glättungsverfahren nach Anspruch 6, **dadurch gekennzeichnet, dass** die Legierung der Oberfläche des zweiten Substrats (6) mit derjenigen der rauhen Oberfläche (4) des ersten Substrats (3) identisch ist.

**8.** Glättungsverfahren nach einem der Ansprüche 1 bis 7, **dadurch gekennzeichnet, dass** die rauhe Oberfläche (4) von der Oberfläche des zweiten Substrats (6) durch wenigstens einen Keil mit einer Dicke, die wenigstens gleich dem Trennungsabstand d ist, getrennt ist.

**9.** Glättungsverfahren nach Anspruch 7, **dadurch gekennzeichnet, dass** es die folgenden Schritte umfasst:

- Vorsehen eines Trägers (7), der einen innerhalb des Trägers (7) angeordneten Schwächungsbereich (8) umfaßt;
- Trennen des Trägers im Bereich des Schwächungsbereichs, um das erste und das zweite Substrat (3, 6) zu bilden, wobei die rauhe Oberfläche (4) des ersten Substrats (3) und die Oberfläche des zweiten Substrats (6) durch den Schwächungsbereich (8) gebildet wird.

**10.** Glättungsverfahren nach Anspruch 9, **dadurch gekennzeichnet, dass** der Schwächungsbereich (8) mittels eines Einbringens von Wasserstoff und/oder von Edelgasen erhalten wird und dass das Trennen einen Wärmebehandlungsschritt umfasst.

**11.** Glättungsverfahren nach Anspruch 9 oder 10, **dadurch gekennzeichnet, dass** das erste und das zweite Substrat (3, 6) mittels Keilen, die um den Umfang der Substrate (3, 6) herum verteilt sind, getrennt sind.

## Claims

**1.** A smoothing process of a rough surface (4) of a first substrate (3) comprising the following steps:

- providing the first substrate (3) with the rough surface (4) made from a semiconductor alloy based on at least two elements chosen from Ga, As, Al, In, P and N;
- placing a second substrate (6) with a surface facing the rough surface (4) of the first substrate (3), the two substrates (3 and 6) being separated by a distance d at least equal to 10 μm, the facing portions of the two substrates (3, 6) defining a confinement space (5);
- heating the first substrate (3) so as to partially desorb one of the elements of the semiconductor alloy and to reach the saturated vapor pressure of this element in the confinement space (5) and to obtain a surface atom mobility that is sufficient to reduce the roughness of the rough surface (4).

**2.** The smoothing process according to claim 1, **characterized in that** the separating distance d is less than 2 mm.

**3.** The smoothing process according to one of claims 1 and 2, **characterized in that** the alloy is a gallium and arsenic alloy and **in that** heating is performed at a temperature higher than or equal to 700 °C.

4. The smoothing process according to one of claims 1 and 2, **characterized in that** the alloy is an indium and phosphorus alloy and **in that** heating is performed at a temperature higher than or equal to 600 °C.

5. The smoothing process according to any one of claims 1 to 4, **characterized in that** the surface of the second substrate (6) comprises a semiconductor alloy based on at least two elements chosen from Ga, As, Al, In, P and N.

6. The smoothing process according to claim 5, **characterized in that** the surface of the second substrate (6) is rough and **in that** simultaneous smoothing of the rough surface (4) and of the surface of the second substrate (6) is performed.

7. The smoothing process according to claim 6, **characterized in that** the alloy of the surface of the second substrate (6) is identical to that of the rough surface (4) of the first substrate (3).

8. The smoothing process according to any one of claims 1 to 7, **characterized in that** the rough surface (4) is separated from the surface of the second substrate (6) by at least one wedge having a thickness at least equal to the separating distance d.

9. The smoothing process according to claim 7, **characterized in that** it comprises the following steps:

   - providing a support (7) comprising a weakened area (8) located inside the support (7);
   - separating the support at the level of the weakened area to form the first and second substrates (3, 6), the rough surface (4) of the first substrate (3) and the surface of the second substrate (6) being formed by the weakened area (8).

10. The smoothing process according to claim 9, **characterized in that** the weakened area (8) is obtained by means of implantation of hydrogen and/or of rare gases, and **in that** separation comprises a heat treatment step.

11. The smoothing process according to claim 9 or 10, **characterized in that** the first and second substrates (3, 6) are separated by means of wedges arranged around the periphery of said substrates (3, 6).

**Figure 1**

**Figure 2**

**Figure 3**

**Figure 4**

Figure 6A

Figure 6B

Figure 6C

## RÉFÉRENCES CITÉES DANS LA DESCRIPTION

**Documents brevets cités dans la description**

- FR 2867307

- JP 2005217374 A

**Littérature non-brevet citée dans la description**

- Surface topography changes during the growth of GaAs by molecular beam epitaxy. *Applied Physics Letters,* 1991, vol. 59 (25